# EUROPÄISCHE PATENTANMELDUNG

(11) **EP 0 986 110 A1**
(43) Veröffentlichungstag der Anmeldung: **15.03.2000**
(21) Anmeldenummer: 98117134.1
(22) Anmeldetag: 10.09.1998
(51) Int. Cl.: H01L 31/103, G08B 17/12, F23N 5/08

(54) **Lichtempfindliches Halbleiterelement und Verwendung zur Regelung von Flammen**

(71) Anmelder: Electrowatt Technology Innovation AG, 6301 Zug (CH)
(72) Erfinder: Pauchard, Alexandre, 1630 Bulle (CH); Popovic, Radivoje, 1025 St-Sulpice (CH); Racz, Robert, 6300 Zug (CH)

(57) **Zusammenfassung**

Das erfindungsgemässe lichtempfindliche Halbleiterelement besteht aus einem Substrat 1, einer Zwischenschicht 2 und einer äusseren Schicht 5, wobei die Zwischenschicht 2 innerhalb des Substrats 1 und die äussere Schicht 5 innerhalb der Zwischenschicht 2 zumindest teilweise eigebettet ist und die Zwischenschicht 2 und die äussere Schicht 5 zur Generierung eines lichtabhängigen Signals R, wie beispielsweise einem Photostrom, eine lichtempfindliche Region 22 bilden. Die äussere Schicht 5, wird dabei in voneinander beabstandete Bereiche 11 aufgeteilt, die durch Zwischenbereiche 13 der Zwischenschicht 2 getrennt sind. Die beabstandeten Bereiche 11 der äusseren Schicht dienen dann bsp. als Anode 30 des lichtempfindlichen Halbleiterelements, die an eine entsprechende Auswerteelektronik angeschlossen werden kann. Durch die beabstandeten Bereiche 11 wird die Bildung einer inaktiven Schicht 12 verhindert, die aufgrund von Rekombinationen von Ladungsträgern zur Reduktion des durch das einfallende Licht erzeugten Photostroms führt

## Beschreibung

Die vorliegende Erfindung betrifft ein lichtempfindliches Halbleiterelement nach dem Oberbegriff des Anspruchs 1 und eine lichtempfindliche Halbleiterelementanordnung nach dem Oberbegriff des Anspruchs 7, sowie eine lichtempfindliche Schaltung nach Anspruch 12 und ein Verfahren zur Regelung von Flammen nach Anspruch 13 unter Verwendung dieses lichtempfindlichen Halbleiterelements bzw. der lichtempfindlichen Halbleiterelementanordnung.

Derartige lichtempfindliche Halbleiterelemente, die auch als Photodiode oder Phototransistor bekannt sind, existieren bereits als sogenannte pn-Übergänge von entsprechend dotierten Halbleiter-Bauelementen und sind beispielsweise in ,,Physics of Semiconducter-Devices", 2^{nd} Edition, S. M. Sze, 1981, John Wiley & Sons, Inc. Verlag, Part V, Chapter 13, "Photodetectors" beschrieben. Diese Photodetektoren bzw. lichtempfindlichen Halbleiterelemente dienen zur Detektion von Licht, d.h. sichtbarem oder nicht sichtbarem Licht, wie beispielsweise UV-Licht oder IR-Licht. Die drei wichtigsten Parameter zur Beschreibung der Qualität solcher lichtempfindlichen Halbleiterelemente sind die Sensitivität, das heißt die spektrale Empfindlichkeit (Empfindlichkeit bei bestimmten Wellenlängen), die Antwortzeit, das heißt die Zeit zwischen dem Einfall des Lichts und der Detektion eines Sensor-Signals und schließlich die Quantum-Effizienz.

Derartige lichtempfindliche Halbleiterelemente sind bereits bekannt, beispielsweise beschreibt A. R. Jones: "Flame failure detection and modern boilers", J. Phys. E.: Sci. Instrum. 21 (1988), 921-928, sogenannte ultraviolet-sensitive Gasentladungsröhren, die eine sehr hohe Sensitivität aufweisen und intrinsisch selektiv sind. Dennoch ist dieser Typ von Photodetektor sehr teuer, zerbrechlich, hat ein großes Ausmaß und benötigt eine sehr hohe Energiezufuhr.

Darüber hinaus sind herkömmliche Silicium-Photodioden bekannt, die mit externen oder integrierten Filtern versehen sind, um dadurch eine gewisse Selektivität zu erhalten. Diese Photodioden sind sehr klein und nahezu unzerbrechlich. Interferenz-Filter können dazu verwendet werden, um eine hohe Selektivität im UV-Bereich zu erhalten, das heißt um sichtbares Licht und am sichtbaren Bereich angrenzendes IR-Licht auszufiltern. Nichtsdestoweniger sind solche UV-Photodioden sehr teuer, da die Interferenz-Filter die Kosten in die Höhe treiben und dadurch die Gesamtschaltung für den Einsatz in Produkten mit hoher Stückzahl unattraktiv machen. Auf der anderen Seite existieren jedoch auch Interferenz-Filter in einer niederen Preisklasse, wobei diese jedoch schlechtere Filtereigenschaften für das sichtbare und das am sichtbaren Bereich liegende IR-Licht aufweisen, so daß hier die Selektivität für die meisten Anwendungen nicht ausreicht.

Eine kommerziell erhältliche UV-Photodiode mit einer hohen Selektivität ist beispielsweise in R. S. Popovic et al. "A silicon ultraviolet detector", Sensors and Actuators, A 21 - A 23, 1990, 553 - 558, beschrieben sowie aus der EP 0 296 371 bekannt, wobei diese UV-Photodioden einem sehr aufwendigen und langwierigen Optimierungsprozeß hinsichtlich der Dotierung der entsprechenden Halbleiterschichten unterzogen werden, um diese hohe Selektivität zu erreichen. Dadurch sind diese Photodioden sehr teuer und eignen sich kaum für den Einsatz in Produkten mit grossen Stückzahlen.

Diese vorbekannten Halbleiterelemente zur Detektion von Licht, d.h. bsp. Photodioden, weisen ein Substrat aus Silicium auf, in welchem eine Zwischenschicht und einer äussere Schicht zumindest teilweise eingebettet sind. Die Zwischenschicht und die äussere Schicht unterscheiden sich durch eine unterschiedliche Dotierung, sind also bsp. p- oder n-dotiert, um den für den Photostrom erforderlichen pn-Übergang zu schaffen. Die Zwischenschicht und die äussere Schicht bilden zur Generierung eines lichtabhängigen Signals, d.h. bsp. des Photostroms, eine lichtempfindliche Region aus, in welcher sich durch die einfallenden Photonen sog. Ladungsträger bilden, d.h. Elektronen und Löcher, die sich im Leitungsband bzw. im Valenzband des Halbleiters befinden. Durch den Transport dieser Ladungsträger und ggf. durch weitere Generierung von Ladungsträgern (avalanche effect) entsteht ein Photostrom, der durch entsprechende Kontakte an der Oberfläche dieser Schichten gemessen werden kann. Je nach Aufbau und Dotierung der entsprechenden Halbleiterschichten kann die Generierung, der Transport und die Geschwindigkeit der Ladungsträger beeinflusst werden. In den meisten Fällen widersprechen sich jedoch die qualitativen Anforderungen mit den strukturellen Möglichkeiten zur Herstellung solcher Bauelemente.

Demnach bieten die herkömmlichen lichtempfindlichen Halbleiterbauelemente entweder eine hohe Selektivität, sind dabei jedoch sehr groß und sehr teuer, oder sie sind klein und billig, besitzen aber eine geringe Selektivität oder eine mangelhafte Effektivität, so dass sie sich nicht zuverlässig für entsprechend relevante elektronische Schaltungen einsetzen lassen. Beispielsweise sind bestimmte lichtempfindliche Halbleiterelemente für Überwachungsschaltungen vorgesehen, die ein "Fail-Safe"-Verhalten garantieren sollen. Hier sind bisher noch keine brauchbaren Lösungen gefunden worden, die gleichzeitig billig und einfach herstellbar sind.

Beispielsweise sind herkömmliche lichtempfindliche Halbleiterelemente für den Einsatz zur Überwachung von Flammen in Brennern von Heizungsanlagen von Privathäusern oder industriellen Gebäuden, für Feueralarmsysteme oder für Gebäudeüberwachungssysteme zu vertretbaren Stückpreisen bei einer genügend hohen Selektivität und genügend quantitativer Effektivität derzeit nicht erhältlich.

Es ist daher die Aufgabe der vorliegenden Erfindung, ein lichtempfindliches Halbleiterelement bzw. eine lichtempfindliche Halbleiterelementanordnung der vorbekannten Art anzugeben, die die Nachteile des Standes der Technik vermeiden, sowohl klein als auch robust sind und darüber hinaus eine sehr hohe Selektivität, Effektivität und ein sehr hohes Detektionsvermögen aufweisen und durch Standardtechnologien bzw. Standardprozesse kostengünstig herstellbar sind.

Diese Aufgabe löst die vorliegende Erfindung durch die Merkmale der unabhängigen Ansprüche 1 und 7. Darüber hinaus wird in Anspruch 12 eine lichtempfindliche Schaltung und in Anspruch 13 ein Verfahren zur Regelung von Flammen unter Verwendung dieses lichtempfindlichen Halbleiterelements bzw. der lichtempfindlichen Halbleiterelementanordnung nach den Merkmalen der Ansprüche 1 und 7 angegeben. Weitere Ausgestaltungen der Erfindung ergeben sich aus den entsprechenden Unteransprüchen.

Das erfindungsgemäße lichtempfindliche Halbleiterelement besteht aus einem Substrat, einer Zwischenschicht und einer äusseren Schicht, wobei die Zwischenschicht innerhalb des Substrats und die äussere Schicht innerhalb der Zwischenschicht zumindest teilweise eigebettet ist und die Zwischenschicht und die äussere Schicht zur Generierung eines lichtabhängigen Signals, wie beispielsweise einem Photostrom, eine lichtempfindliche Region bilden. Die äussere Schicht, die beispielsweise aus P⁺-dotiertem Silicium besteht, wird dabei in voneinander beabstandete Bereiche aufgeteilt, die durch Zwischenbereiche der Zwischenschicht getrennt sind. Die Zwischenschicht besteht dann beispielsweise aus N-dotiertem Silicium, während das Substrat aus P-dotiertem Silicium besteht und sowohl die Zwischenschicht als auch die äussere Schicht an der Oberfläche des lichtempfindlichen Halbleiterelements trägt.

Die beabstandeten Bereiche der äusseren Schicht dienen dann bsp. als Anode des lichtempfindlichen Halbleiterelements, welches als Photodiode dient und an eine entsprechende Auswerteelektronik angeschlossen werden kann. Die Zwischenschicht weist darüber hinaus einen N⁺-dotierten Bereich auf, der dann bsp. als Kathode des lichtempfindlichen Halbleiterelements dient, der ggf. mit einem P⁺-dotierten Bereich des Substrats kurzgeschlossen ist.

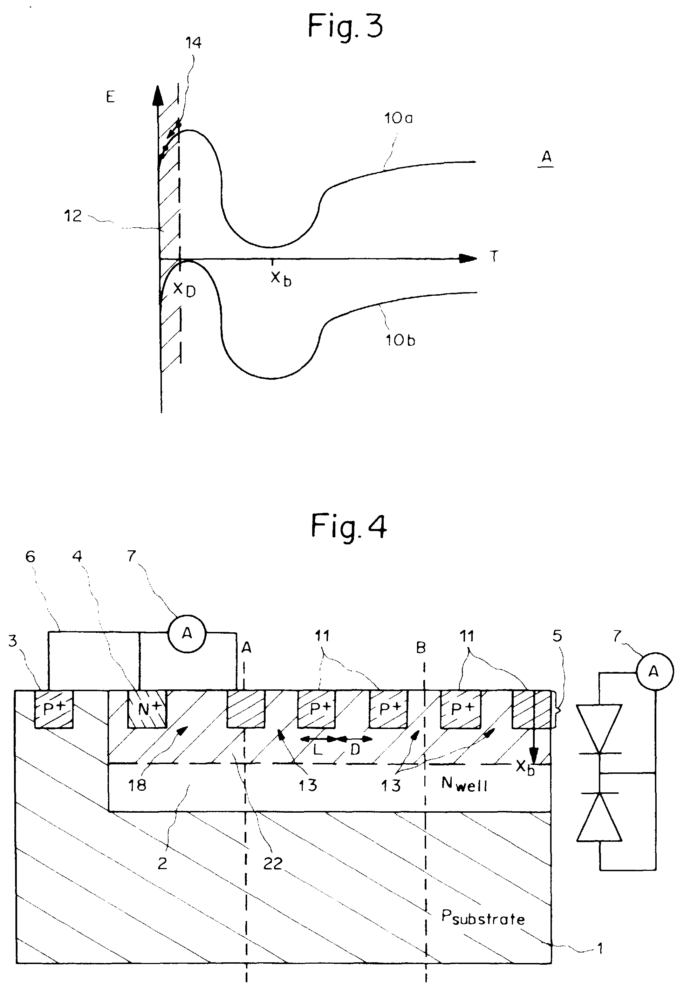

Die sehr hohe Selektivität des erfindungsgemäßen lichtempfindlichen Halbleiterelements wird durch die Trennung der äusseren Schicht in voneinander beabstandeten Bereichen erreicht. Die äussere Schicht ist dabei in der Zwischenschicht (N_{well}) eingebettet, so dass sich eine Potentialsperre bildet, die eine photosensitive Region bis zu einer bestimmten Tiefe, von der Oberfläche der äusseren Schicht aus gemessen, begrenzt. Die Konzentration der Dotierung an der Oberfläche der äusseren Schicht (beispielsweise eine P⁺-Dotierung von Bor) nimmt bei den herkömmlichen Halbleiterelementen aufgrund von Dotierungseffekten und der Rückverteilung ("redistribution") von Dotierungsatomen ab, obwohl gerade hier zum Erreichen eines hohen Photostroms eine besonders hohe Dotierung gewünscht wird. Die voneinander beabstandeten Bereiche verhindern die Bildung dieser "inaktiven" Schicht an der Oberfläche der äusseren Schicht, die sich bildet, wenn die äussere Schicht durchgängig in die Zwischenschicht eingebettet wird (vgl. Fig. 3). Dieser inaktive Bereich resultiert aus der Rekombination von durch Photonen erzeugten Ladungsträgern, d.h. Elektronen und Löcher, die dann nicht mehr zur Erzeugung des Photostroms dienen können und somit zu einem unerwünschten Abfall des erzeugten Photostroms führen.

Bei solch einem lichtempfindlichen Halbleiterelement ist es besonders wichtig, daß die Elektronen und Löcher nicht rekombinieren, sondern getrennt zu der jeweiligen Anode bzw. Kathode fließen, um dort durch eine Ausleseelektronik entsprechend detektiert zu werden. Die Rekombination der durch das einfallende Licht erzeugten Elektronen und Löcher an der äußeren Oberfläche der äusseren Schicht, an der an sich die Erzeugung von Elektronen und Löchern am größten ist, reduziert drastisch den erzeugten Photostrom. Diese Rekombination kommt, wie oben beschrieben, insbesondere dadurch zustande, daß die dotierte äussere Schicht im äußeren Oberflächenbereich, das heißt in der obenerwähnten inaktiven Zone, eine reduzierte Konzentration von dotierten Bohratomen aufweist, was verschiedene physikalische Gründe hat. Beispielsweise kommt es an der äußeren Oberfläche zu sehr starken Dotierungseffekten und zur Umverteilung von Bohratomen, so daß hier die Konzentration von dotierten Boratomen geringer wird, obwohl gerade an dieser Stelle eine hohe Borkonzentration erforderlich ist.

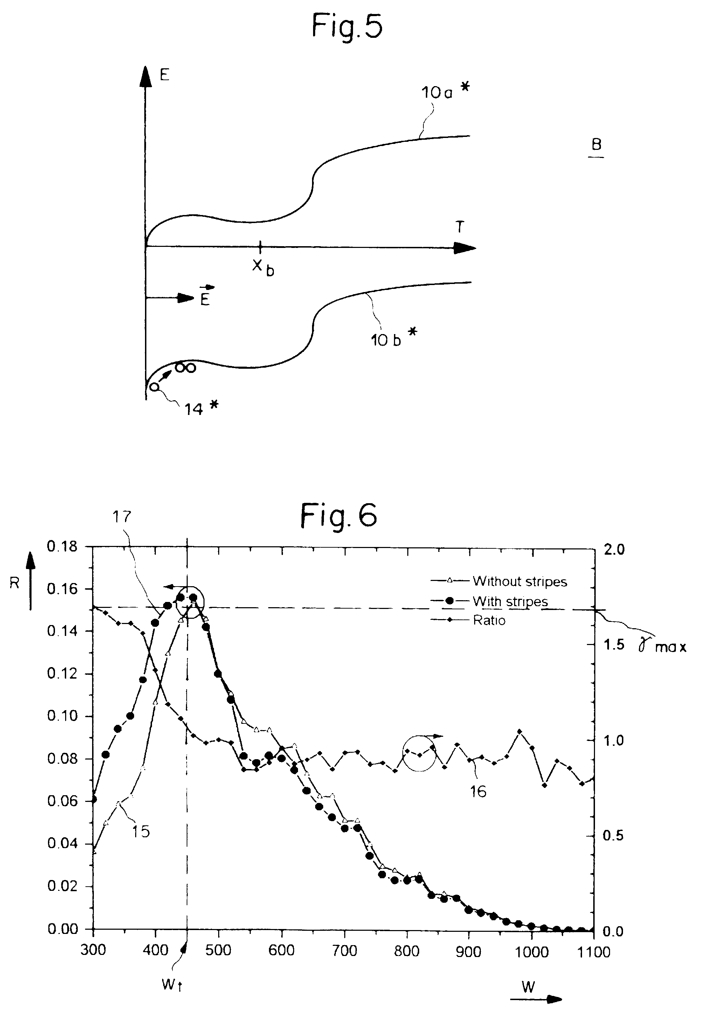

Durch das Vorsehen von beabstandeten Bereichen der äusseren Schicht wird die Erzeugung der inaktiven Schicht weitgehend verhindert. Es ergibt sich ein verändertes Profil des Energiebandes zwischen der unteren Grenze des Leitungsbandes und der oberen Grenze des Valenzbandes der entsprechend N-dotierten Silizium-Atome zwischen den beabstandeten Bereichen der äusseren Schicht (vgl. Fig. 5), so daß hier - unterstützt durch das dadurch erzeugte Potential zwischen den beabstandeten Bereichen - die in diesem Bereich existierenden Minoritätsträger (Löcher) nach unten abgedrängt werden und so keine bzw. nur eine geringfügige Rekombination von Elektronen und Löchern stattfinden kann. Dadurch ergibt sich eine an der Oberfläche der äusseren Schicht gewünschte hohe Responsivität gegenüber einfallendem Licht, da die durch die entsprechend einfallenden Photonen erzeugten Elektronen und Löcher fast vollständig zur Anode bzw. zur Kathode abfließen, ohne vorher selbst bereits zu rekombinieren. Dadurch wird der Photostrom für einen bestimten Wellenlängenbereich, für den die Photodiode ausgelegt ist, fast vollständig genutzt.

Durch diesen geometrischen Trick wird nicht nur eine sehr hohe Selektivität gegenüber einfallendem Licht, sondern auch die Realisierung eines sehr preisgünstigen und mit StandardTechnologien herstellbaren Bauelement erreicht, das sowohl den Ansprüchen für ein Bauelement, das in hohen Stückzahlen hergestellt wird, als auch hinsichtlich der Qualität des Bauelements gerecht wird.

Sämtliche Schichten können dabei standardmäßig als integrierter Sensor aufgebaut und mittels der bekannten CMOS-Technologie gemeinsam in ein und demselben Substrat eindiffundiert werden. Durch die integrierte Bauweise des gesamten lichtempfindlichen Halbleiterelements, das mit einer Auswerteelektronik verbunden ist, die vorteilhafterweise ebenfalls auf ein- und demselben Substrat durch CMOS-Technologie realisiert wird, kann dieses zu sehr niedrigen Preisen hergestellt werden. Dadurch lassen sich für die verschiedensten Anwendungen sehr preisgünstige, kleine und robuste lichtempfindliche Halbleiter herstellen, die gemeinsam in einem Prozeß, evtl. zusammen mit der Auswerteelektronik, auf ein- und demselben Chip aufgebaut werden können.

Je nach verwendeter Dotierung der einzelnen Schichten bzw. je nach Dicke der lichtempfindlichen Region lassen sich die unterschiedlichsten Bereiche des Lichts detektieren, wobei stets durch die Beabstandung der entsprechenden Bereiche an der Oberfläche des lichtempfindlichen Halbleiterelements die gewünschte Selektivität erreicht wird. Die lichtempfindliche Region, die die beabstandeten Bereiche, die Zwischenbereiche und einen Teil der Zwischenschicht umschliesst, weist zur Detektion von bestimmten Wellenlängenbereichen des einfallenden Lichts eine Tiefe (X_{b}) in der Grössenordnung von etwa einer Wellenlänge (Wₜ) des einfallenden Lichts auf.

Beispielsweise hat die lichtempfindliche Region zur Detektion von ultraviolettem Licht eine Tiefe von etwa 0,01 bis 0,8 µm, insbesondere 0,1 bis 0,4 µm und bevorzugt 0,5 µm. Die Zwischenbereiche weisen dabei vorteilhafterweise eine Breite auf, die in etwa doppelt so groß ist wie die Tiefe der lichtempfindlichen Region, da dadurch zum einen die voneinander beabstandeten Bereiche möglichst klein werden, darüber hinaus aber die Zwischenbereiche nicht zu groß werden, um so einen Kriechstrom, das heißt die Diffusion von Löchern in das darunterliegende Substrat zu verhindern.

Die Erfindung offenbart darüber hinaus eine lichtempfindliche Halbleiterelementanordnung, die aus einem oder mehreren Substraten, mindestens zweier Zwischenschichten und mindestens zweier äusseren Schichten besteht, wobei die Zwischenschichten innerhalb des Substrats und die äusseren Schichten innerhalb der entsprechenden Zwischenschichten zumindest teilweise eingebettet sind. Das Substrat, die Zwischenschichten und die äusseren Schichten bilden zur Generierung lichtabhängiger Signale mindestens zwei lichtempfindliche Regionen. Eine erste äussere Schicht besteht aus voneinander beabstandeten Bereichen, die durch Zwischenbereiche der entsprechenden Zwischenschicht getrennt sind. Die Funktion dieser Bereiche ist identisch zu der oben beschriebenen Funktion, d.h. die Vermeidung der inaktiven Schicht an der Oberfläche der ersten äusseren Schicht. Die erste äussere Schicht bildet dann mit der entsprechenden Zwischenschicht eine erste lichtempfindliche Region mit einer bestimmten Tiefe, die, ähnlich wie oben beschrieben, durch die Potentialsperre des pn-Übergangs begrenzt ist. Eine zweite äussere Schicht ist mit der entsprechenden Zwischenschicht kurzgeschlossen, so dass sich eine zweite lichtempfindliche Region unterhalb einer Tiefe dieser zweiten Schichten ausbildet, die in etwa der Grösse der ersten bestimmten Tiefe entspricht und die aus Teilen der zweiten Zwischenschicht und dem Substrat besteht.

Die erste lichtempfindliche Region dient zur Detektion eines vorbestimmten Wellenlängenbereichs (Frequenzbereich) des einfallenden Lichts, während die zweite lichtempfindliche Region zur Detektion eines anderen Wellenlängenbereichs des einfallenden Lichts, vorteilhafterweise zur Detektion eines dem vorbestimmten Wellenlängenbereich benachbarten Wellenlängenbereich des einfallenden Lichts dient. Die entsprechenden Schichten des Halbleiterelements werden dabei derart mit einer Ausleseelektronik verbunden, dass der durch die erste lichtempfindliche Region detektierte benachbarte Wellenlängenbereich-Anteil weitgehend unterdrückbar ist. Dies ist dann realisierbar, wenn die Grösse des durch die zweite lichtempfindliche Region detektierten Signals durch das einfallende Licht in etwa dem durch die erste lichtempfindliche Region generierten Signals in dem Bereich entspricht, in dem sich beide überlappen. Die zweite lichtempfindliche Region ist derart bemessen, dass das zweite Signal, welches durch diese Region erzeugt wird bei einem einfallenden Licht ab einer vorbestimmten Wellenlänge (W_{tIR}) in etwa gleich gross ist wie das erste Signal, das durch die erste Region erzeugt wird.

Die erste lichtempfindliche Region ist bsp. vornehmlich zur Detektion von UV-Licht und die zweite lichtempfindliche Region vornehmlich zur Detektion von IR-Licht ausgelegt. Die erste lichtempfindliche Region erzeugt einen ersten Photostrom und die zweite lichtempfindliche Region einen zweiten Photostrom, wobei die zweite lichtempfindliche Region derart bemessen ist, dass der zweite Photostrom bei einem einfallenden Licht ab einer Wellenlänge von etwa 400 - 500 nm in etwa gleich gross ist wie der erste Photostrom.

Dieses neben dem "ersten" lichtempfindlichen Halbleiterelement angeordnete "zweite" lichtempfindliche Halbleiterelement dient dann beispielsweise zur Detektion von IR-Licht, wobei beide Halbleiterelemente derart miteinander verschaltet werden können, daß der Photostrom des IR-Sensors vom Photostrom des UV-Sensors abgezogen wird, so daß hier eine erhöhte UV-Selektivität erreicht wird. Je nach Schichtdicke der entsprechenden lichtempfindlichen Regionen lassen sich dabei die entsprechend erzeugten Photoströme derart einstellen, daß sich sowohl der UV-Photostrom als auch der IR-Photostrom in den sich überlappenden Bereichen entsprechen, so daß bei einer Subtraktion beider Ströme ein Ausgangssignal entsteht, welches außerhalb des UV-Bereiches nahezu Null ist.

Beide lichtempfindlichen Halbleiterelemente, das heißt die entsprechenden Schichten, lassen sich wiederum auf ein- und demselben Substrat realisieren, wobei auch hier die CMOS-Technologie verwendet werden kann. Die Kombination einer UV-Photodiode mit der entsprechenden IR-Photodiode erübrigt den Einsatz von teuren Interferenz- oder Farbfiltern. Dadurch ergibt sich insgesamt eine sehr preisgünstige aber hoch selektive Photodiode bzw. lichtempfindliches Halbleiterelement zur Detektion von unterschiedlichen Spektralbereichen des einfallenden Lichts.

Mittels dieser lichtempfindlichen Halbleiterelemente lassen sich lichtempfindliche Schaltungen realisieren, die klein, kostengünstig, frequenz- bzw. wellenlängenselektiv, schnell, robust, zuverlässig und effektiv sind, wobei sämtliche Schichten des Halbleiterbauelements oder der lichtempfindlichen Halbleiterelementanordnung und/oder der Ausleseelektronik in CMOS-Technologie auf einem Substrat gemeinsam herstellbar sind. Dadurch entfallen teure Filter, Anschlussvorrichtungen u.ä.

Die erfindungsgemässen Halbleiterbauelemente lassen sich für Verfahren zur Regelung von Flammen einsetzen, insbesondere in Brennern von Heizungsanlagen, die mittels eines Gemisches von Luft und Brennstoff brennen. Diese Flammen brennen je nach eingestellter Luft-Brennstoff-Mischung in unterschiedlicher Intensität und mit unterschiedlichen Verbrennungswerten, wobei jeweils Licht in einem anderen Spektralbereich emmittiert wird. Durch die sehr frequenzselektiven Halbleiterelemente nach der vorliegenden Erfindung lassen sich bestimmte Spektralbereiche bzw.
bestimmte Wellenlängenbereiche des durch die Flamme erzeugten Lichts detektieren und anhand der Existenz und/oder der Intensität dieser Wellenlängenbereiche das Gemisch von Luft und Brennstoff regeln. Möglich ist dabei die Anordnung einer Vielzahl der lichtempfindlichen Halbleiteranordnungen, die jeweils unterschiedliche Wellenlängenbereiche selektieren, und derart miteinander verschaltet werden, dass aufgrund der Frequenzverteilung die Verbrennung und/oder die Intensität der Flamme geregelt wird. Diese "Matrix" von "Frequenzdetektoren" kann durch die vorliegende Erfindung ohne zusätzliche Filter oder anderen Bauelementen auf einem gemeinsamen Chip realisiert werden. Das ergibt eine Art "Kamera" anch dem Prinzip der CCD-Kamera für sichtbares Licht, wobei nicht alle Elemente der Matrix gleichzeitig Ströme an die Auswerteelektronik schicken, sonder nur solche, die auf die gerade emmittierte Frequenz ansprechen.

Einige bevorzugte Ausführungsbeispiele der vorliegenden Erfindung sollen anhand der folgenden Zeichnungen näher erläutert werden. Dabei zeigen:
- Fig. 1: Ein lichtempfindliches Halbleiterelement herkömmlicher Bauart,
- Fig. 2: Ein Diagramm der Dotierungsdichte des Halbleiterelements entlang der Linie A nach Fig. 1,
- Fig. 3: Die schematische Darstellung des äusseren Energiebandes des Halbleiterelements entlang der Linie A nach Fig. 1,
- Fig. 4: Ein lichtempfindliches Halbleiterelement nach der Erfindung,
- Fig. 5: Die schematische Darstellung des äusseren Energiebandes des Halbleiterelements entlang der Linie B nach Fig. 4,
- Fig. 6: Ein Diagramm zur Darstellung der Responsivität des erfindungsgemässen Halbleiterelements gegenüber den herkömmlichen Halbleiterelementen,
- Fig. 7: Ein lichtempfindliches Halbleiterelement für IR-Licht,
- Fig. 8: Eine lichtempfindliche Halbleiterelementanordnung nach der Erfindung mit den Halbleiterelementen nach Fig. 4 und Fig. 7,
- Fig. 9: Ein Diagramm zur Darstellung der Photoströme der lichtempfindlichen Halbleiterelementanordnung nach Fig. 8, und
- Fig. 10: Die überlagerten Signale nach Fig. 9.

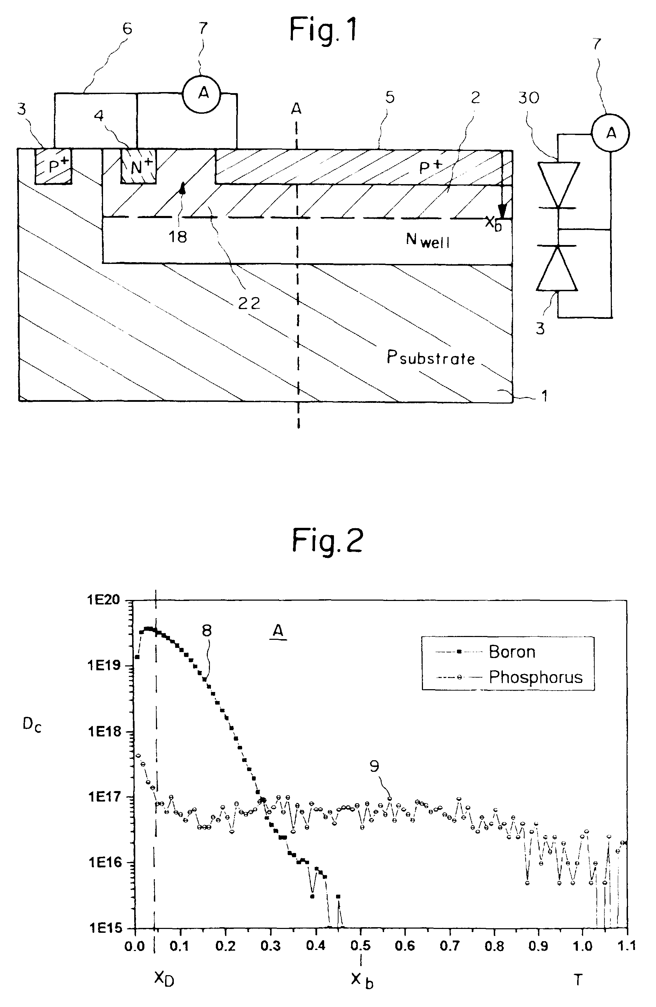

Fig. 1 zeigt ein lichtempfindliches Halbleiterelement herkömmlicher Bauart, mit einem Substrat 1, einer Zwischenschicht 2 und einer äusseren Schicht 5, wobei die Zwischenschicht 2 innerhalb des Substrats 1 und die äussere Schicht 5 innerhalb der Zwischenschicht 2 teilweise eingebettet ist und
die Zwischenschicht 2 und die äussere Schicht 5 zur Generierung eines lichtabhängigen Signals eine lichtempfindliche Region 22 bilden (schraffiert dargestellt). Die lichtempfindliche Region 22 ist nach unten hin mittels einer Potentialsperre bis zu einer Tiefe X_{b} hinbegrenzt. Zwischen der äusseren Schicht 5, die P⁺-dotiert ist und einem N⁺-dotierten Bereich 4 befindet sich ein Zwischenraum 18, in dem sich ein Potential aufbaut. Die äussere Schicht 5 und teilweise die N-dotierte Zwischenschicht (N_{well}) bilden gemeinsam die lichtempfindliche Region 22.

Auf der rechten Seite der Fig. 1 ist die Verschaltung des lichtempfindlichen Halbleiterelements dargestellt, wobei die äussere Schicht 5 die Anode 30 darstellt und ein P⁺-dotierter Bereich 3 innerhalb des P-dotierten Substrats 1 mit der Kathode 4 über eine Leitung 6 kurzgeschlossen ist. Ein Strommesser 7 detektiert den durch die lichtempfindliche Region 22 generierten Strom. Das Halbleiterelement nach Fig. 1 stellt insbesondere eine UV-selektive Photodiode dar, die für die Detektion von UV-Licht ausgelegt sein soll.

Fig. 2 zeigt ein Diagramm der Dotierungsdichte des Halbleiterelements entlang der Linie A nach Fig. 1. Die Hochachse des Diagrammes gibt die Konzentration der Dotieratome D_{c} in Partikel/cm³ an. Die Querachse gibt die Tiefe T in µm von der Oberfläche der äusseren Schicht 5 in Richtung des darunterliegenden Substrats 1 an. Die Zwischenschicht 2 ist innerhalb des P-dotierten Substrats 1 mittels Phosphoratomen (Donatoren) N-dotiert, die äussere Schicht 5 ist innerhalb der Zwischenschicht 2 mittels Boratomen (Akzeptoren) P⁺-dotiert. Anhand des Diagramms lässt sich erkennen, dass die Konzentration 8 der Boratome bis zu einer Tiefe X_{b} von etwa 500 nm kontinuierlich abnimmt, während die Konzentration 9 der Phosphoratome bis zu dem Übergang zwischen Zwischenschicht 2 und Substrat 1 (in etwa die doppelte Tiefe X_{b}) nahezu konstant ist.

Die Dotierungsprofile der Fig. 2 entsprechen also einem typischen 0,5 µm Standard C-MOS Prozess. Zu erkennen ist, dass die Dotierungsdichte, d.h. die Konzentration 8 der Boratome bei einer Tiefe x_{D} am grössten ist, d.h. von dieser Tiefe x_{D} bis hin zur Oberfläche wieder abnimmt. Dieser unerwünschte Effekt aufgrund von Dotierungseffekten und der "Redistribution" von Dotierungsatomen ist unvermeidlich, obwohl gerade hier zum Erreichen eines hohen Photostroms eine besonders hohe Dotierung gewünscht wird. Dadurch bildet sich am äusseren Randbereich der äusseren Schicht 5 eine "tote Schicht" 12 auf der Siliciumoberfläche, gerade dort, wo die meisten Photonen des einfallenden Lichts (also z.B. UV-Licht) absorbiert werden sollte.

Fig. 3 zeigt die schematische Darstellung des äusseren Energiebandes des Materials des Halbleiterelements entlang der Linie A nach Fig. 1 mit den Dotierungskonzentrationen nach Fig. 2. Dargestellt ist das untere Valenzband 10b und das obere Leitungsband 10a und deren Energieniveaus von der Oberfläche in Richtung auf das untere Substrat 1 hin gemessen. Zu erkennen ist die Potentialsperre bei der Tiefe X_{b}, die die lichtempfindliche Region 22 begrenzt. Zu erkennen ist aber auch, dass an der Oberfläche 12 der äusseren Schicht 5 bis hin zu der Tiefe x_{D} die Energieniveaus beider Bänder 10a und 10b abfallen. Dieser Effekt resultiert aus der oben beschriebenen "toten Schicht" 12. Die durch die Photonen generierten Minoritätsträger 14 (Elektronen) in der äusseren Schicht 5, also auch an der äusseren Oberfläche, rekombinieren innerhalb der "toten Schicht" 12 durch die reduzierte Borkonzentration 8 aufgrund der oben beschriebenen Effekte. Dadurch können diese Elektronen (und die dazu korrespondierenden Löcher, d.h. die Majoritätsträger) nicht zum Photostrom beitragen und es ergibt sich eine geringere Empfindlichkeit, d.h. eine geringere Selektivität des Halbleiterelements für einfallendes Licht.

Fig. 4 zeigt ein lichtempfindliches Halbleiterelement nach der Erfindung. Das erfindungsgemäße lichtempfindliche Halbleiterelement besteht aus einem Substrat 1, einer Zwischenschicht 2 und einer äusseren Schicht 5, wobei die Zwischenschicht 2 innerhalb des Substrats 1 und die äussere Schicht 5 innerhalb der Zwischenschicht 2 zumindest teilweise eigebettet ist und die Zwischenschicht 2 und die äussere Schicht 5 zur Generierung eines lichtabhängigen Signals, wie beispielsweise einem Photostrom, eine lichtempfindliche Region 22 bilden. Die äussere Schicht 5, aus P⁺-dotiertem Silicium besteht, wird dabei in voneinander beabstandete Bereiche 11 aufgeteilt, die durch Zwischenbereiche 13 der Zwischenschicht 2 getrennt sind. Die Zwischenschicht 2 besteht aus N-dotiertem Silicium, während das Substrat 1 aus P-dotiertem Silicium besteht und sowohl die Zwischenschicht 2 als auch die äussere Schicht 5 an der Oberfläche des lichtempfindlichen Halbleiterelements trägt.

Die beabstandeten Bereiche 11 der äusseren Schicht 5 dienen ebenso wie zu Fig. 1 beschrieben als Anode 30 des lichtempfindlichen Halbleiterelements. Die Verschaltung ist ebenfalls identisch zur Fig. 1.

Die sehr hohe Selektivität des erfindungsgemäßen lichtempfindlichen Halbleiterelements wird durch die Trennung der äusseren Schicht 5 in die voneinander beabstandeten Bereiche 11 erreicht. Die voneinander beabstandeten Bereiche 11, die eine Breite L aufweisen und im Abstand D voneinander beabstandet sind, verhindern die Bildung der inaktiven, d.h. "toten" Schicht an der Oberfläche der äusseren Schicht 5.

Es ergibt sich ein verändertes Profil des in Fig. 5 schematisch dargestellten äusseren Energiebandes des Halbleiterelements entlang der Linie B nach Fig. 4. Das Energieband zwischen der unteren Grenze des Leitungsbandes 10a* und der oberen Grenze des Valenzbandes 10b* der entsprechend N-dotierten Silizium-Atome zwischen den beabstandeten Bereichen 11 der äusseren Schicht 5, d.h. innerhalb der Zwischenbereiche 13, weisen zwischen der Oberfläche der äusseren Schicht 5 und der Tiefe X_{b} einen von der Tiefe X_{b} in Richtung der Oberfläche gesehenen nach unten gekrümmten Verlauf auf, so daß hier - unterstützt durch das dadurch erzeugte Potential zwischen den beabstandeten Bereichen 11 - die in diesem Bereich existierenden Minoritätsträger 14 * (Löcher) in Richtung der Tiefe X_{b}, d.h. von der Oberfläche weg in Richtung des Substrats 1, abgedrängt werden. Die "tote Schicht" 12 wird durch das zwischen den beabstandeten Bereichen 11 erzeugte Potential minimiert. So kann keine bzw. nur eine geringfügige Rekombination von Elektronen und Löchern am oberen Rand der äusseren Schicht stattfinden.

Wie in Fig. 2 ersichtlich, nimmt die Konzentration 9 der Phosphoratome der Zwischenschicht 2, d.h. innerhalb der Zwischenbereiche 13 der äusseren Schicht 5 zum Rand der äusseren Schicht 5 hin zu, welches auf der Segregation am Silicium/Siliciomdioxid-Übergang beruht. Dieser Zuwachs verursacht am Energieband der Fig. 5 den leichten Energieabfall beider Bänder 10a* und 10b* in der Nähe der Oberfläche der äusseren Schicht 5, so dass die Löcher 14* in die Tiefe abgedrängt werden und die unerwünschte Rekombination verhindert wird. Die "tote Zone" wird um einen Faktor L/(L+D) reduziert. Die Breite L der voneinander beabstandeten Bereiche 11 kann dabei so schmal wie technisch realisierbar ausgelegt werden, es existiert jedoch eine optimale Distanz D zwischen diesen Bereichen 11, die in etwa doppelt so gross ist wie die Tiefe X_{b}. Eine schmalere Distanz D würde zu einer Verstärkung der "toten Schicht" 12, eine grössere Distanz D würde die Löcher zu weit nach unten abdrängen, so dass diese in das Substrat 1 diffundieren und dadurch ebenfalls die Lichtsensitivität geschwächt würde.

Dadurch ergibt sich eine an der Oberfläche der äusseren Schicht gewünschte hohe Responsivität gegenüber einfallendem Licht, da die durch die entsprechend einfallenden Photonen erzeugten Elektronen und Löcher fast vollständig zur Anode bzw. zur Kathode abfließen, ohne vorher selbst bereits zu rekombinieren. Dadurch wird der Photostrom für einen bestimten Wellenlängenbereich, für den die Photodiode ausgelegt ist, fast vollständig genutzt.

Fig. 6 zeigt ein Diagramm zur Darstellung der Responsivität des erfindungsgemässen Halbleiterelements gegenüber den herkömmlichen Halbleiterelementen. Dargestellt ist die Responsivität, bzw. das durch die lichtempfindliche Region 22 erzeugte Signal R für ein Halbleiterelement gegenüber der Wellenlänge W (in nm) des einfallenden Lichts ohne der Verwendung der erfindungsgemässen Zwischenbereiche 13 (durch die Kurve 15 dargestellt), für ein Halbleiterelement mit der Verwendung der erfindungsgemässen Zwischenbereiche 13 (durch die Kurve 17 dargestellt) und das Verhältnis r beider Kurven 15 und 17 untereinander (durch die Kurve 16 dargestellt). Zu erkennen ist, dass das Signal R der Kurve 17 für das erfindungsgemässe Halbleiterelement bis zu einer vorbestimmten Wellenlänge Wₜ stärker ist als das Signal R herkömmlicher Halbleiterelemente. Bei der Wellenlänge von etwa 300 nm ist das Verhältnis r maximal und weist einen Wert von etwa rₘₐₓ = 1,65 auf. Die Breite L hat dabei einen Wert von etwa 0,6 µm, die Distanz D in etwa 1,0 µm.

Das erfindungsgemässe Halbleiterelement weist darüber hinaus weitere Vorteile auf. Der Shunt-Widerstand Rₛₕ, der dem Spannungs-Stromverhältnis im Bereich um 0V entspricht, ist indirekt proportional zu der Grösse der Übergangszone bzw. der Sperrschichtfläche und nimmt mit grösser werdender Distanz D zu. Da dieser Widerstand indirekt proportional ist zur erzeugten Fehlspannung der Photodiode, ist diese umso kleiner, je grösser der Widerstand ist. Dieser ist bei der erfindungsgemässen "Streifenschicht" 5, d.h. durch die beabstandeten Bereiche 11 grösser, wodurch diese Fehlspannung reduziert wird. Dies ist insbesondere bei hohen Temperaturen wichtig, bei welchen diese Fehlspannung kritisch werden kann. Darüber hinaus wird durch die Vorsehung der beabstandeten Bereiche 11 die Kapazität der Photodiode reduziert, die zu verzögerten Antwortzeiten aufgrund der Wechselwirkung mit der Signalspannung führt. Auch dies ist auf die Reduktion der Grösse der Übergangszone bzw. der Sperrschichtfläche zurückzuführen.

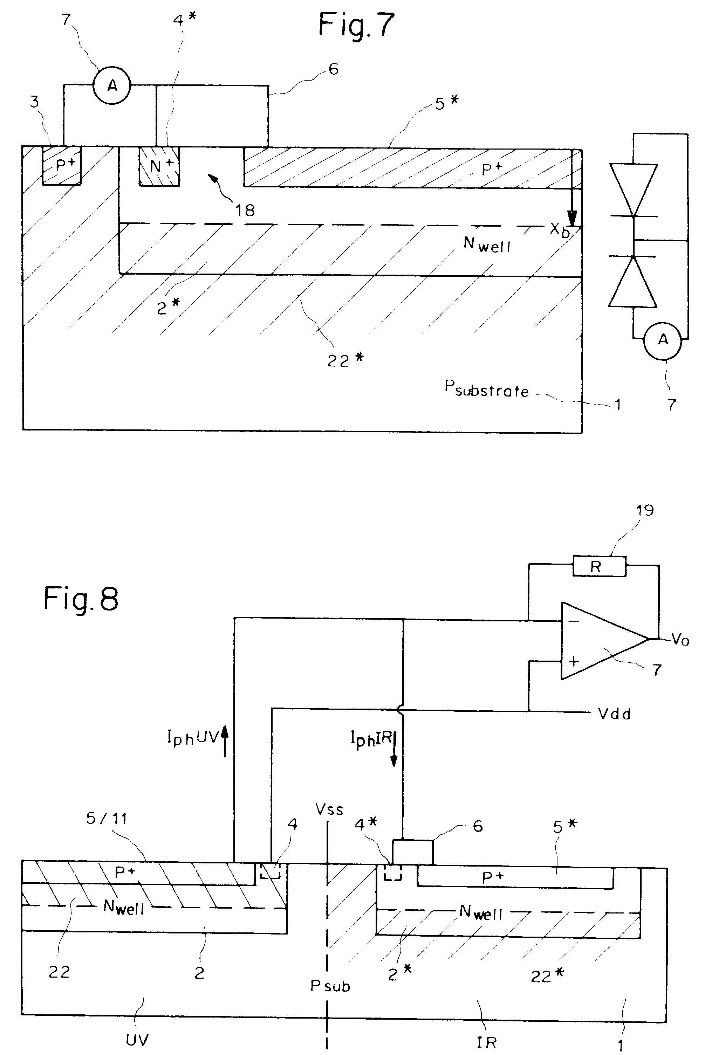

Fig. 7 zeigt ein lichtempfindliches Halbleiterelement mit unterschiedlicher Verschaltung. Die Anordnung entspricht jener der Fig. 1, mit dem Unterschied, dass nicht der P⁺-dotierte Bereich 3 innerhalb des P-dotierten Substrats 1 sondern die äussere Schicht 5 mit der Kathode 4* über eine Leitung 6 kurzgeschlossen ist. Dadurch bildet sich die lichtempfindliche Region 22* ab einer Tiefe X_{b} zwischen der Zwischenschicht 2* und dem Substrat 1. Ein Strommesser 7 detektiert den durch die lichtempfindliche Region 22* generierten Strom. Das Halbleiterelement nach Fig. 7 stellt insbesondere eine IR-selektive Photodiode dar, die durch die unterschiedliche Verschaltung jene Ladungsträger detektiert, die durch die grösseren Wellenlängen des einfallenden Lichts in tieferliegenden Schichten ab einer Tiefe von etwa 500 nm generiert werden.

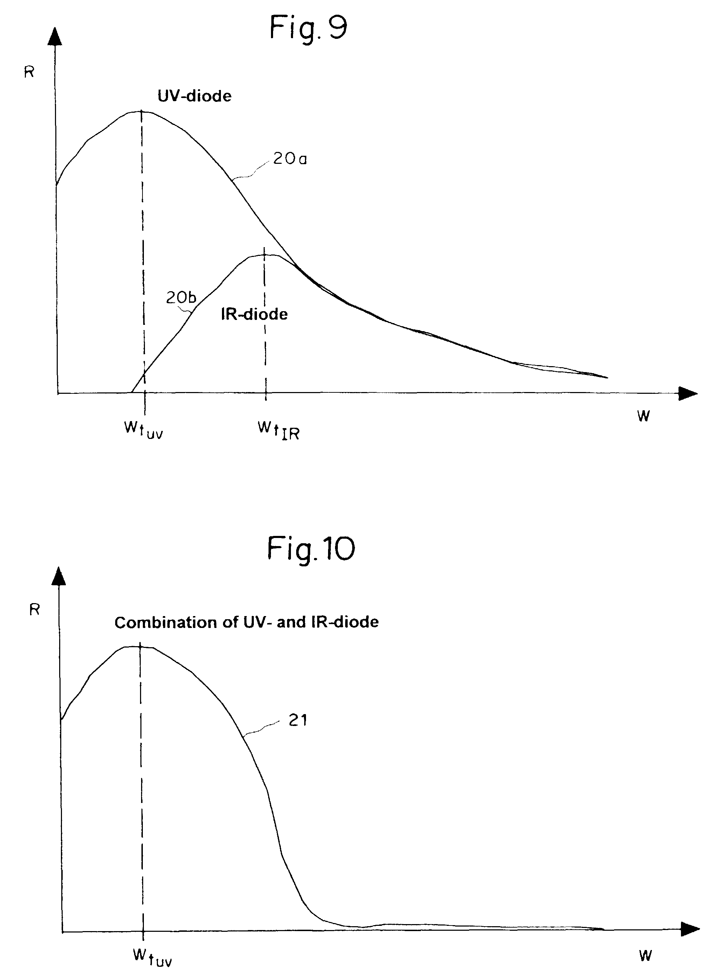

Fig. 8 zeigt nun eine lichtempfindliche Halbleiterelementanordnung nach der Erfindung mit den Halbleiterelementen nach Fig. 4 und Fig. 7. 7. Die lichtempfindliche Halbleiterelementanordnung besteht aus einem Substrat 1, zweier Zwischenschichten 2, 2* und zweier äusseren Schichten 5, 5*, wobei die Zwischenschichten 2, 2* innerhalb des Substrats 1 und die äusseren Schichten 5, 5* innerhalb der entsprechenden Zwischenschichten 2, 2* teilweise eingebettet sind, und das Substrat 1, die Zwischenschichten 2, 2* und die äusseren Schichten 5, 5* zur Generierung lichtabhängiger Signale 20a, 20b (vgl. Fig. 9) mindestens zwei lichtempfindliche Regionen 22, 22* bilden.Die erste äussere Schicht 5 besteht aus den voneinander beabstandeten Bereichen 11 und bildet mit der entsprechenden Zwischenschicht 2 eine erste lichtempfindliche Region 22 mit einer Tiefe X_{b}. Die zweite äussere Schicht 5* mit der entsprechenden Zwischenschicht 2* ist gem. Fig. 7 kurzgeschlossen, so dass sich eine zweite lichtempfindliche Region 22* unterhalb der Tiefe X_{b} bildet, die aus Teilen der zweiten Zwischenschicht 2* und dem Substrat 1 besteht.

Das Substrat liegt auf dem Potential V_{SS}, die Zwischenschicht 2 auf dem Potential V_{dd}. Die erste äussere Schicht 5, die zwiete äussere Schicht 5* und die zweite Zwischenschicht 5* liegen auf dem durch den Ausgangssverstärker (OP-Amp) 7 hergestellten virtuellen Potential V_{dd}. Der Eingangsbereich des Ausgangssverstärkers 7 muss daher eine Polarisation um das Potetntial V_{dd} herum zulassen, um kleinste Photoströme bereits messen zu können. Statt V_{dd} kann jedoch auch eine positive Referenzspannung zur Polarisation des Ausgangsverstärkers benutzt werden.

Wie in Fig. 9 dargestellt, generiert die erste lichtempfindliche Region 22 ein erstes Signal (20a) und die zweite lichtempfindliche Region 22* ein zweites Signal 20b, wobei die zweite lichtempfindliche Region 22* derart bemessen ist, dass das zweite Signal 20b bei einem einfallenden Licht ab einer vorbestimmten Wellenlänge W_{tIR} in etwa gleich gross ist wie das erste Signal 20a.

Insbesondere eignet sich die erste lichtempfindliche Region 22 zur Detektion von UV-Licht und die zweite lichtempfindliche Region 22* zur Detektion von IR-Licht, indem die erste lichtempfindliche Region 22 einen ersten Photostrom I_{phUV} und die zweite lichtempfindliche Region 22* einen zweiten Photostrom I_{phIR} generiert, und indem die zweite lichtempfindliche Region 22* derart bemessen ist, dass der zweite Photostrom I_{phIR} bei einem einfallenden Licht ab einer Wellenlänge von etwa 400 - 500 nm in etwa gleich gross ist wie der erste Photostrom I_{phUV}. Ein Operationsverstärker 7 detektiert das in Fig. 10 dargestellte kombinierte Signal 21, welches aus der Subtraktion der beiden Signale 20a und 20b resultiert, wobei dieses Signal bei der Wellenlänge W_{tUV} am stärksten ist und in Richtung der Wellenlänge W_{tIR}, für die das zweite Halbleiterelement ausgelegt ist, stark abfällt. Somit ergibt sich eine verbesserte Selektivität, d.h. ein "intergrierter" Filter zur scharfen Detektion einzelner Wellenlängenbereiche.

## Patentansprüche

1. Lichtempfindliches Halbleiterelement, bestehend aus
einem Substrat (1), einer Zwischenschicht (2) und einer äusseren Schicht (5),
wobei die Zwischenschicht (2) innerhalb des Substrats (1) und die äussere Schicht (5) innerhalb der Zwischenschicht (2) zumindest teilweise eingebettet ist und
die Zwischenschicht (2) und die äussere Schicht (5) zur Generierung eines lichtabhängigen Signals (R) eine lichtempfindliche Region (22) bilden,
**dadurch gekennzeichnet**,
dass die äussere Schicht (5) aus voneinander beabstandeten Bereichen (11) besteht, die durch Zwischenbereiche (13) der Zwischenschicht (2) getrennt sind.

2. Halbleiterelement nach Anspruch 1,
**dadurch gekennzeichnet**,
dass das Substrat (1) aus P-dotiertem, die Zwischenschicht (2) bzw. die Zwischenbereiche (13) aus N-dotiertem und die beabstandeten Bereiche (11) aus P⁺-dotiertem Silicium besteht bzw. bestehen und die beabstandeten Bereiche (11) als Anode (30) des lichtempfindlichen Halbleiterelements dienen.

3. Halbleiterelement nach Anspruch 1 oder 2,
**dadurch gekennzeichnet**,
dass die lichtempfindliche Region (22), die die beabstandeten Bereiche (11), die Zwischenbereiche (13) und einen Teil der Zwischenschicht (2) umschliesst, zur Detektion von bestimmten Wellenlängenbereichen des einfallenden Lichts eine Tiefe (X_{b}) in der Grössenordnung von etwa einer Wellenlänge (Wₜ) des einfallenden Lichts aufweist,.

4. Halbleiterelement nach einem der vorhergehenden Ansprüche,
**dadurch gekennzeichnet**,
dass die lichtempfindliche Region (22) zur Detektion von utraviolettem Licht eine Tiefe (X_{b}) in der Grössenordnung von etwa 0,01 bis 0,5 µm, vorzugsweise 0,1 bis 0,4 µm, aufweist.

5. Halbleiterelement nach einem der vorhergehenden Ansprüche,
**dadurch gekennzeichnet**,
dass die Zwischenbereiche (13) eine Breite (D) aufweisen, die in etwa doppelt so gross ist wie die Tiefe (X_{b}) der lichtempfindlichen Region (22).

6. Halbleiterelement nach einem der vorhergehenden Ansprüche,
**dadurch gekennzeichnet**,
dass ein Teil der Zwischenschicht (2), der ggf. N⁺-dotiert ist, als Kathode (4) des lichtempfindlichen Halbleiterelements dient, und
dass Kathode (4), Anode (30) und ggf. das Substrat (1) an eine Ausleseelektronik (7, 19) angeschlossen sind, die sich ebenfalls auf dem Substrat (1) befindet.

7. Lichtempfindliche Halbleiterelementanordnung, bestehend aus einem oder mehrerer Substrate (1), mindestens zweier Zwischenschichten (2, 2*) und mindestens zweier äusseren Schichten (5, 5*), wobei die Zwischenschichten (2, 2*) innerhalb des Substrats (1) und die äusseren Schichten (5, 5*) innerhalb der entsprechenden Zwischenschichten (2, 2*) zumindest teilweise eingebettet sind, und das Substrat (1), die Zwischenschichten (2, 2*) und die äusseren Schichten (5, 5*) zur Generierung lichtabhängiger Signale (20a, 20b) mindestens zwei lichtempfindliche Regionen (22, 22*) bilden,
**dadurch gekennzeichnet**,
dass eine erste äussere Schicht (5) aus voneinander beabstandeten Bereichen (11) besteht, die durch Zwischenbereiche (13) der entsprechenden Zwischenschicht (2) getrennt sind, dass die erste äusseren Schicht (5) mit der entsprechenden Zwischenschicht (2) eine erste lichtempfindliche Region (22) mit einer Tiefe (X_{b}) bildet, und
dass eine zweite äussere Schicht (5*) mit der entsprechenden Zwischenschicht (2*) kurzgeschlossen ist, so dass sich eine zweite lichtempfindliche Region (22*) unterhalb der Tiefe (X_{b}) bildet, die aus Teilen der zweiten Zwischenschicht (2*) und dem Substrat (1) besteht.

8. Halbleiterelementanordnung nach Anspruch 7,
**dadurch gekennzeichnet**,
dass die erste lichtempfindliche Region (22) zur Detektion eines vorbestimmten Wellenlängenbereichs des einfallenden Lichts und die zweite lichtempfindliche Region (22*) zur Detektion eines anderen, Wellenlängenbereichs des einfallenden Lichts dient.

9. Halbleiterelementanordnung nach Anspruch 7 oder 8,
**dadurch gekennzeichnet**,
dass die erste lichtempfindliche Region (22) zur Detektion eines vorbestimmten Wellenlängenbereichs des einfallenden Lichts und die zweite lichtempfindliche Region (22*) zur Detektion eines benachbarten Wellenlängenbereichs dient, und
dass die entsprechenden Schichten (2, 2*, 5, 5*) derart mit einer Ausleseelektronik (7, 19) verbindbar sind, dass der durch die erste lichtempfindliche Region (22) detektierte benachbarte Wellenlängenbereich-Anteil weitgehend unterdrückbar ist.

10. Halbleiterelementanordnung nach einem der Ansprüche 7 bis 9,
**dadurch gekennzeichnet**,
dass die erste lichtempfindliche Region (22) ein erstes Signal (20a) und die zweite lichtempfindliche Region (22*) ein zweites Signal (20b) generiert, und dass die zweite lichtempfindliche Region (22*) derart bemessen ist, dass das zweite Signal (20b) bei einem einfallenden Licht ab einer vorbestimmten Wellenlänge (W_{tIR}) in etwa gleich gross ist wie das erste Signal (20a).

11. Halbleiterelementanordnung nach einem der Ansprüche 7 bis 10,
**dadurch gekennzeichnet**,
dass die erste lichtempfindliche Region (22) vornehmlich zur Detektion von UV-Licht und die zweite lichtempfindliche Region (22*) vornehmlich zur Detektion von IR-Licht dient, und dass die erste lichtempfindliche Region (22) einen ersten Photostrom (I_{phUV}) und die zweite lichtempfindliche Region (22*) einen zweiten Photostrom (I_{phIR}) generiert, und dass die zweite lichtempfindliche Region (22*) derart bemessen ist, dass der zweite Photostrom (I_{phIR}) bei einem einfallenden Licht ab einer Wellenlänge von etwa 400 - 500 nm in etwa gleich gross ist wie der erste Photostrom (I_{phUV}).

12. Lichtempfindliche Schaltung mit einem Halbleiterbauelement nach einem der Ansprüche 1 bis 6 oder einer lichtempfindlichen Halbleiterelementanordnung nach einem der Ansprüche 7 bis 11,
**dadurch gekennzeichnet**,
dass sämtliche Schichten des Halbleiterbauelements oder der lichtempfindlichen Halbleiterelementanordnung und/oder der Ausleseelektronik (7, 19) in CMOS-Technologie auf einem Substrat (1) gemeinsam herstellbar sind.

13. Verfahren zur Regelung von Flammen, insbesondere in Brennern von Heizungsanlagen, die mittels eines Gemisches von Luft und Brennstoff brennen, unter Verwendung des Halbleiterbauelements nach einem der Ansprüche 1 - 6 oder der lichtempfindlichen Halbleiterelementanordnung nach einem der Ansprüche 7 bis 11 oder der Schaltung nach Anspruch 12,
**dadurch gekennzeichnet**,
dass bestimmte Wellenlängenbereiche des durch die Flamme erzeugten Lichts detektiert werden und anhand der Existenz und/oder der Intensität dieser Wellenlängenbereiche das Gemisch von Luft und Brennstoff geregelt wird.

14. Verfahren nach Anspruch 13,
**dadurch gekennzeichnet**,
dass das Vorhandensein einer Flamme detektiert wird.

15. Verfahren nach Anspruch 13 oder 14,
**dadurch gekennzeichnet**,
dass eine Vielzahl von lichtempfindlichen Halbleiterelementanordnungen nebeneinander angeordnet werden, die jeweils unterschiedliche Wellenlängenbereiche selektieren, und derart miteinander verschaltet werden, dass aufgrund der Frequenzverteilung die Verbrennung und/oder die Intensität der Flamme geregelt wird.
